# EUROPÄISCHE PATENTSCHRIFT

(11) **EP 4 075 489 B1**
(45) Veröffentlichungstag und Bekanntmachung des Hinweises auf die Patenterteilung: **28.02.2024**
(21) Anmeldenummer: 21168164.8
(22) Anmeldetag: 13.04.2021
(51) Int. Cl.: H01L 21/68

(54) **VERFAHREN ZUM HERSTELLEN VON HALBLEITERSCHEIBEN MIT AUS DER GASPHASE ABGESCHIEDENER EPITAKTISCHER SCHICHT IN EINER ABSCHEIDEKAMMER**
METHOD FOR MANUFACTURING SEMICONDUCTOR WAFERS HAVING AN EPITAXIAL LAYER DEPOSITED FROM THE GAS PHASE IN A DEPOSITION CHAMBER
PROCÉDÉ DE FABRICATION DE PLAQUETTES SEMI-CONDUCTRICES À COUCHE ÉPITAXIALE DÉPOSÉE EN PHASE GAZEUSE DANS UNE CHAMBRE DE DÉPÔT

(43) Veröffentlichungstag der Anmeldung: 19.10.2022
(73) Patentinhaber: Siltronic AG, 81677 München (DE)
(72) Erfinder: Stettner, Thomas, 83329 Waging am See (DE)
(74) Vertreter: Staudacher, Wolfgang

(56) Entgegenhaltungen:
- JP-B2- 5 704 461
- US-A1- 2006 086 462

## Beschreibung

Gegenstand der Erfindung ist ein Verfahren zum Herstellen von Halbleiterscheiben mit aus der Gasphase abgeschiedener epitaktischer Schicht in einer Abscheidekammer.

Halbleiterscheiben mit epitaktischer Schicht werden zur Herstellung elektronischer Bauelemente benötigt. Das Abscheiden der epitaktischen Schicht findet üblicherweise in einer Abscheidekammer statt, die als Einzelscheiben-Reaktor ausgebildet ist. Die zu beschichtende Substratscheibe wird auf einem Suszeptor abgelegt, und ein Abscheidegas bei einer Abscheidetemperatur durch die Abscheidekammer über die sich mit dem Suszeptor drehende Substratscheibe geleitet.

Ein Qualitätskriterium von Halbleiterscheiben mit epitaktischer Schicht ist die Randgeometrie, insbesondere die Gleichförmigkeit der Dicke der epitaktischen Schicht im Randbereich der Halbleiterscheibe.

### Stand der Technik / Probleme

In JP 2016 213 218 A ist ein Verfahren zur Herstellung von Halbleiterscheiben aus einkristallinem Silizium mit epitaktischer Schicht aus einkristallinem Silizium beschrieben. Es wird empfohlen, dass ein Roboter, der die Substratscheibe auf den Suszeptor eines Abscheide-Reaktors ablegt, zu einer Ablageposition bewegt wird, in der das Zentrum der Substratscheibe wegen einer Korrekturvorgabe nicht über dem Zentrum des Suszeptors liegt. Es wurde herausgefunden, dass andernfalls die Substratscheiben während des Abscheidens der epitaktischen Schicht im statistischen Mittel nicht zentriert auf dem Suszeptor liegen. Liegt die Substratscheibe während des Abscheidens der epitaktischen Schicht nicht konzentrisch in der Tasche des Suszeptors, hat das eine nachteilige Auswirkung auf die Gleichförmigkeit der Dicke der epitaktischen Schicht. Darüber hinaus kann eine solche Lageabweichung eine unerwünschte Bildung von Partikeln zur Folge haben, insbesondere wenn dadurch ein Kontakt des Rands der Substratscheibe mit dem Suszeptor einhergeht.

Die Korrekturvorgabe wird von einem Mittelwert abgeleitet, der die mittlere Abweichung der Lage des Zentrums von Substratscheiben vom Zentrum des Suszeptors während vorangegangener Beschichtungsvorgänge beschreibt. Mit der Korrekturvorgabe ist die Erwartung verknüpft, während eines Beschichtungsvorgangs eine Lage des Zentrums der Substratscheibe zu erreichen, die um den Betrag der mittleren Abweichung näher am Zentrum des Suszeptors ist, als wenn auf die Korrekturvorgabe verzichtet werden würde.

Die Erfinder der vorliegenden Erfindung haben festgestellt, dass ein Festlegen der Korrekturvorgabe, das sich allein an der Lageabweichung während vorangegangener Beschichtungsvorgänge orientiert, verbesserungswürdig ist.

Es ist daher die Aufgabe der Erfindung, eine Verbesserung aufzuzeigen.

Die Aufgabe der Erfindung wird gelöst durch ein Verfahren zum Herstellen von Halbleiterscheiben mit aus der Gasphase abgeschiedener epitaktischer Schicht in einer Abscheidekammer, umfassend
das Ablegen einer Substratscheibe auf einem Suszeptor mit kreisförmigem Umfang durch einen Roboter, wobei der Roboter die Substratscheibe in eine Ablageposition bewegt und auf dem Suszeptor ablegt, wobei in der Ablageposition das Zentrum der Substratscheibe wegen einer Korrekturvorgabe nicht über dem Zentrum des Suszeptors liegt; und
das Abscheiden einer epitaktischen Schicht auf der Substratscheibe, dadurch gekennzeichnet, dass
eine erste Anzahl von Substratscheiben, die einen spezifischen Widerstand aufweisen, der in einen ersten Bereich fällt, vom Roboter mit einer ersten Korrekturvorgabe in die Ablageposition bewegt werden und eine zweite Anzahl von Substratscheiben, die einen spezifischen Widerstand aufweisen, der in einen zweiten Bereich fällt, vom Roboter mit einer zweiten Korrekturvorgabe in die Ablageposition bewegt werden, wobei die erste und zweite Korrekturvorgabe voneinander abweichen.

Die Umsetzung der vorliegenden Erfindung berücksichtigt die Erkenntnis, dass das Ausmaß einer möglichen Fehllage der Substratscheibe während des Abscheidens der epitaktischen Schicht auch von den Eigenschaften des Substrats abhängt, insbesondere vom Anteil an Dotierstoff im Substrat und des damit eingestellten spezifischen elektrischen Widerstands des Substrats (nachfolgend gekürzt als Widerstand bezeichnet). Erfindungsgemäß wird daher vorgeschlagen, die Korrekturvorgabe als Funktion des Widerstands der Substratscheibe zu betrachten und für eine Substratscheibe mit einem Widerstand, der in einen ersten Bereich fällt, eine erste Korrekturvorgabe vorzusehen, die abweicht von einer zweiten Korrekturvorgabe für eine Substratscheibe mit einem spezifischen Widerstand, der in einen zweiten Bereich fällt. Der erste und zweite Bereich sind disjunkt, das heißt, ein bestimmter Widerstand liegt nicht gleichzeitig im ersten und im zweiten Bereich.

Die erste Korrekturvorgabe wird als Mittelwert berechnet, der die mittlere Abweichung der Lage des Zentrums von Substratscheiben vom Zentrum des Suszeptors während vorangegangener Beschichtungsvorgänge beschreibt, wobei nur solche Substratscheiben berücksichtigt werden, deren Widerstand in den ersten Bereich fällt. Dementsprechend wird die zweite Korrekturvorgabe als Mittelwert berechnet, der die mittlere Abweichung der Lage des Zentrums von Substratscheiben vom Zentrum des Suszeptors während vorangegangener Beschichtungsvorgänge beschreibt, wobei nur solche Substratscheiben berücksichtigt werden, deren Widerstand in den zweiten Bereich fällt. Für Substratscheiben mit einem Widerstand in einem anderen Bereich, der zu den ersten und zweiten Bereichen disjunkt ist, wird entsprechend eine andere Korrekturvorgabe berechnet, die von der ersten und der zweiten Korrekturvorgabe verschieden ist.

Zur Berechnung des Mittelwerts (arithmetisches Mittel) werden Lageabweichungen von vorzugsweise mindestens 10, besonders bevorzugt mindestens 20 Substratscheiben einbezogen, die vorzugsweise unmittelbar vor der zu beschichtenden Substratscheibe beschichtet wurden und einen Widerstand im Bereich des Widerstands der zu beschichtenden Substratscheibe aufweisen.

Substratscheiben, auf denen eine epitaktische Schicht erfindungsgemäß abgeschieden wird, sind Halbleiterscheiben, die einen Dotierstoff enthalten, vorzugsweise Substratscheiben aus einkristallinem Silizium.

Die Erfindung wird nachfolgend mit Verweis auf Zeichnungen näher beschrieben.

### Kurzbeschreibung der Figuren

**Fig. 1** zeigt in Schnittdarstellung eine Vorrichtung zum Abscheiden einer epitaktischen Schicht aus der Gasphase auf eine Substratscheibe mit dafür typischen Merkmalen.
**Fig. 2** zeigt die Positionen eines ersten und zweiten Mittelwerts von Lageabweichungen von Substratscheiben zweier unterschiedlicher Widerstandsbereiche relativ zum Zentrum des Suszeptors.
**Fig. 3** zeigt die Verteilung der Zentren von Substratscheiben mit einem Widerstand eines ersten Bereichs nach dem Ablegen auf dem Suszeptor relativ zum Zentrum des Suszeptors in einem Polarkoordinaten-Gitter.
**Fig. 4** zeigt die Verteilung der Zentren von Substratscheiben mit einem Widerstand eines zweiten Bereichs nach dem Ablegen auf dem Suszeptor relativ zum Zentrum des Suszeptors in einem Polarkoordinaten-Gitter.

### Liste der verwendeten Bezugszeichen

- **1**: oberer Deckel
- **2**: unterer Deckel
- **3**: Abscheidekammer
- **4**: Substratscheibe
- **5**: Suszeptor
- **6**: Vorheizring
- **7**: obere Auskleidung
- **8**: untere Auskleidung
- **9**: obere Gaseintrittsöffnungen
- **10**: Zentrum des Suszeptors
- **11**: oberer Gasauslass
- **12**: untere Gaseintrittsöffnungen
- **13**: unterer Gasauslass
- **14**: erste mittlere Position des Zentrums abgelegter Substratscheiben
- **15**: zweite mittlere Position des Zentrums abgelegter Substratscheiben
- **16**: Vektor
- **17**: Vektor

### Detaillierte Beschreibung erfindungsgemäßer Ausführungsbeispiele

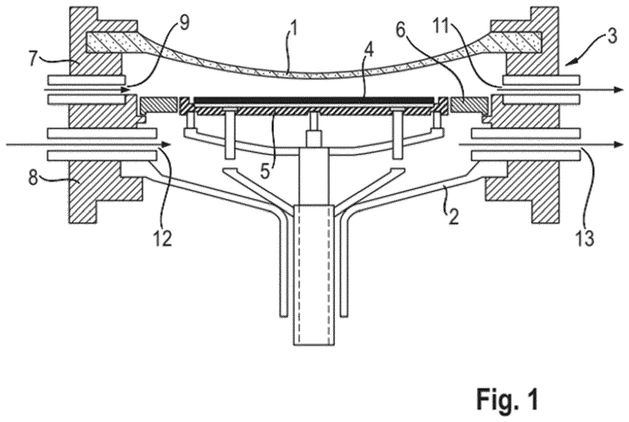

Die in Fig.1 dargestellte Vorrichtung zum Abscheiden einer epitaktischen Schicht auf einer Substratscheibe umfasst eine Abscheidekammer 3 mit einem oberen Deckel 1 und einem unteren Deckel 2 und obere und untere Auskleidungen 7 und 8, die einen Reaktionsraum umschließen. Außerhalb der Abscheidekammer 3 vorhandene obere und untere Lampenbänke sind nicht dargestellt. Mittels der Strahlungsenergie der Lampen wird die Abscheidekammer auf die Temperatur gebracht, die für die Gasphasenabscheidung notwendig ist.

Für einen Beschichtungsvorgang wird eine Substratscheibe 4 auf einem Suszeptor 5 abgelegt, der von unten durch Arme eines Trägers drehbar gehalten wird. Zuvor wird die Substratscheibe auf einen Endeffektor eines Roboters gelegt und vom Roboter zu einer Ablageposition bewegt. Um den Suszeptor herum ist ein Vorheizring 6 angeordnet. Die Substratscheibe 4 kann mittels Hebestiften, die durch den Suszeptor 5 durchgeführt sind, auf dem Suszeptor 5 abgelegt und nach dem Beschichten vom Suszeptor 5 weggehoben werden.

Beim Beschichten der Substratscheibe 4 wird Abscheidegas durch obere Gaseintrittsöffnungen 9, die in der oberen Auskleidung 7 vorgesehen sind, in die Abscheidekammer 3 entlang einer Strömungsrichtung über die Substratscheibe zu einem oberen Gasauslass 11 gleitet. Darüber hinaus können optional untere Gaseintrittsöffnungen 12 und ein unterer Gasauslass 13 vorgesehen sein, um ein Spülgas unter dem Suszeptor 5 hindurch zum unteren Gasauslass 13 zu leiten.

Wird die Ablageposition für den Roboter derart eingestellt, dass das Zentrum der Substratscheibe senkrecht über dem Zentrum des Suszeptors liegt, besteht eine vergleichsweise hohe Wahrscheinlichkeit, dass nach der Ablage der Substratscheibe deren Zentrum nicht im Zentrum des Suszeptors liegt. Der Grund dafür sind insbesondere thermische Spannungen, die sich lösen, wodurch das Zentrum der Substratscheibe aus der vorgesehenen Lage verschoben wird.

Es wurde nun herausgefunden, dass der Betrag der Verschiebung vom Zentrum des Suszeptors umso größer ist, je mehr Dotierstoff die Substratscheiben enthalten, also mit abnehmendem Widerstand der Substratscheiben ansteigt. Erfindungsgemäß wird diese Erkenntnis bei der Berechnung der Korrekturvorgabe berücksichtigt, die die Ablageposition mitbestimmt, in die der Roboter eine Substratscheibe vor deren Ablage auf den Suszeptor bewegt. Die Korrekturvorgabe wird durch Mittelung von Lageabweichungen zuvor beschichteter Substratscheiben berechnet, wobei zur Mittelung nur Daten von Substratscheiben herangezogen werden, deren Widerstand annähernd gleich ist, also im selben vorbestimmten Bereich liegt. Der Begriff Lageabweichung beschreibt die Abweichung der Position des Zentrums einer abgelegten Substratscheibe relativ zum Zentrum des Suszeptors. Der Roboter verwendet für eine zu beschichtende Substratscheibe diejenige Korrekturvorgabe, die für den Widerstand dieser Substratscheibe berechnet wurde. Ein erster Bereich mit vergleichsweise hohem Widerstand kann beispielsweise 11 bis 12 Ohmcm umfassen, ein zweiter Bereich mit vergleichsweise niedrigem spezifischem Widerstand beispielsweise 9 bis 10 Ohmcm.

Ohne die vorgeschlagene widerstandsabhängige Mittelung würde mittels Mittelung der Lageabweichungen eine Korrekturvorgabe resultieren, die weniger genau wäre, weil der Einfluss der Widerstände herausgemittelt würde. Die Korrekturvorgabe sollte jedoch möglichst genau sein, weil sich eine zentrierte Lage der Substratscheibe auf dem Suszeptor vorteilhaft auf die Randgeometrie der resultierenden Halbleiterscheibe mit epitaktischer Schicht auswirkt und auch das Risiko abnimmt, dass während des Abscheidens der epitaktischen Schicht Partikel erzeugt werden.

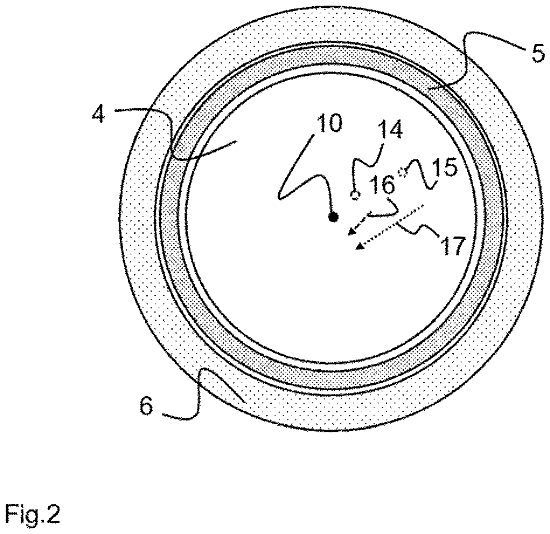

Fig.2 zeigt eine Substratscheibe 4, die auf einem Suszeptor 5 abgelegt ist, so dass das Zentrum 10 des Suszeptors 5 und das Zentrum der Substratscheibe 4 zusammenfallen. In dieser Zielposition liegt die Substratscheibe 4 konzentrisch zum Suszeptor 5 und zum Vorheizring 6. Ohne eine Korrekturvorgabe würde das Zentrum der Substratscheibe abhängig von deren spezifischen Widerstand auf oder in der Nähe derjenigen mittleren Position liegen, die für ihren Widerstandsbereich berechnet wurde, beispielsweise auf oder in der Nähe der ersten mittleren Position 14 im Fall eines spezifischen Widerstands, der vergleichsweise hoch ist, oder auf oder in der Nähe der zweiten mittleren Position 15 im Fall eines spezifischen Widerstands, der vergleichsweise niedrig ist. In der Zeichnung sind die Positionen 14 und 15 unrealistisch weit vom Zentrum 10 des Suszeptors entfernt platziert, um die Erfindung darstellen zu können. Tatsächlich haben übliche Lageabweichungen einen Abstand von nicht mehr als 1000 µm vom Zentrum 10 des Suszeptors.

Die erste mittlere Position 14 hat einen Abstand zum Zentrum 10 des Suszeptors 5, der der Länge des Vektors 16 entspricht. Die zweite mittlere Position 15 hat einen Abstand zum Zentrum 10 des Suszeptors 5, der der Länge des Vektors 17 entspricht. Wird der Vektor 16 beziehungsweise der Vektor 17 verschoben, so dass sein Anfang mit dem Zentrum 10 des Suszeptors zusammenfällt, zeigt die Spitze des Vektors zur Ablageposition, in die der Roboter die Substratscheibe mit ihrem Zentrum bewegen muss, damit eine zu erwartende Lageabweichung kompensiert wird. Die Vektoren 16 und 17 repräsentieren also mögliche Korrekturvorgaben für den Roboter.

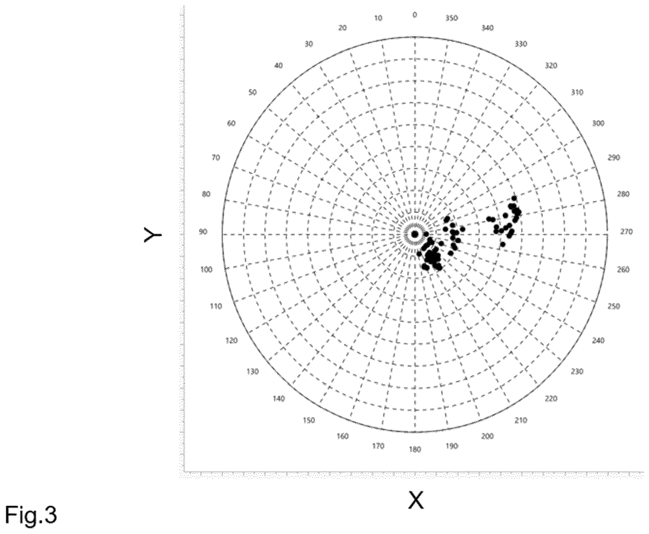

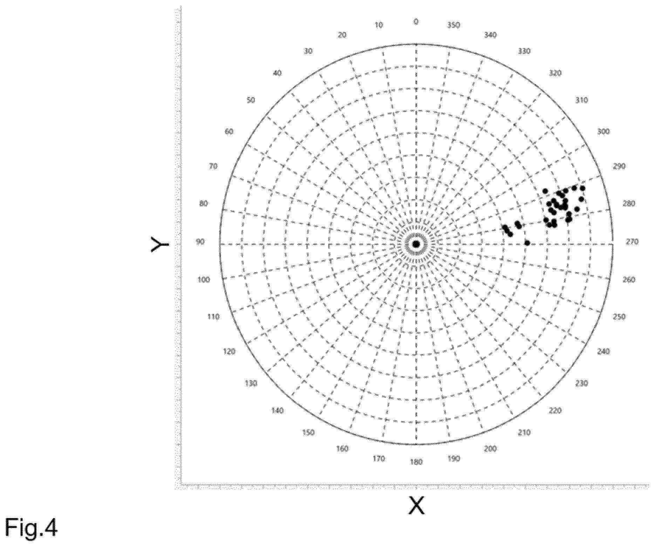

Fig.3 und Fig.4 zeigen für einen Widerstandsbereich von 11 - 12 Ohmcm beziehungsweise für einen Widerstandsbereich von 9 - 10 Ohmcm gemessene Lageabweichungen von mit Bor dotierten Substratscheiben aus einkristallinem Silizium mit einem Durchmesser von 300 mm in einem Polarkoordinaten-Gitter. Der Vergleich der dargestellten Verteilungen der Lageabweichungen macht deutlich, dass der Betrag der Lageabweichung vom Dotierstoff-Anteil abhängt.

## Patentansprüche

1. Verfahren zum Herstellen von Halbleiterscheiben mit aus der Gasphase abgeschiedener epitaktischer Schicht in einer Abscheidekammer (3), umfassend das Ablegen einer Substratscheibe (4) auf einem Suszeptor (5) mit kreisförmigem Umfang durch einen Roboter, wobei der Roboter die Substratscheibe (4) in eine Ablageposition bewegt und auf dem Suszeptor (5) ablegt, wobei in der Ablageposition das Zentrum der Substratscheibe (4) wegen einer Korrekturvorgabe nicht über dem Zentrum (10) des Suszeptors liegt; und das Abscheiden einer epitaktischen Schicht auf der Substratscheibe (4), **dadurch gekennzeichnet, dass** eine erste Anzahl von Substratscheiben, die einen spezifischen Widerstand aufweisen, der in einen ersten Bereich fällt, vom Roboter mit einer ersten Korrekturvorgabe in die Ablageposition bewegt werden und eine zweite Anzahl von Substratscheiben, die einen spezifischen Widerstand aufweisen, der in einen zweiten Bereich fällt, vom Roboter mit einer zweiten Korrekturvorgabe in die Ablageposition bewegt werden, wobei die erste und zweite Korrekturvorgabe voneinander abweichen.

2. Verfahren nach Anspruch 1, **dadurch gekennzeichnet, dass** der Betrag der ersten Korrekturvorgabe größer oder kleiner ist als der Betrag der zweiten Korrekturvorgabe, abhängig davon ob der erste Bereich einen spezifischen Widerstand abdeckt, der kleiner oder größer ist, als der spezifische Widerstand, den der zweite Bereich abdeckt.

## Claims

1. A process for producing semiconductor wafers with epitaxial layer deposited from the gas phase in a deposition chamber, comprising
the placement of a substrate wafer on a susceptor with circular perimeter by a robot, where the robot moves the substrate wafer into a placement position and places it on the susceptor, with a corrective precept causing the center of the substrate wafer not to lie above the center of the susceptor in the placement position; and
the deposition of an epitaxial layer on the substrate wafer, wherein
a first number of substrate wafers having a specific resistance which falls within a first range are moved into the placement position by the robot with a first corrective precept, and a second number of substrate wafers having a specific resistance which falls within a second range are moved into the placement position by the robot with a second corrective precept, where the first and second corrective precepts differ from one another.

2. The process as claimed in claim 1, wherein the amount of the first corrective precept is larger or smaller than the amount of the second corrective precept, depending on whether the first range covers a specific resistance which is smaller or larger than the specific resistance which is covered by the second range.

## Revendications

1. Procédé de fabrication de plaquettes semiconductrices à couche épitaxiale déposée en phase gazeuse dans une chambre de dépôt (3), comprenant les étapes consistant à
poser une plaquette de substrat (4) sur un suscepteur (5) à circonférence circulaire par un robot, dans lequel le robot déplace la plaquette de substrat (4) dans une position de pose et la pose sur le suscepteur (5), dans lequel dans la position de pose, le centre de la plaquette de substrat (4) ne se trouve pas au-dessus du centre (10) du suscepteur en raison d'une correction prédéfinie ; et
déposer une couche épitaxiale sur la plaquette de substrat (4),
**caractérisé en ce qu'**un premier nombre de plaquettes de substrat qui présentent une résistance spécifique qui tombe dans une première plage sont déplacées par le robot avec une première correction prédéfinie dans la position de pose, et un deuxième nombre de plaquettes de substrat qui présentent une résistance spécifique qui tombe dans une deuxième plage sont déplacées par le robot avec une deuxième correction prédéfinie dans la position de pose, la première et la deuxième correction prédéfinie étant différente l'une de l'autre.

2. Procédé selon la revendication 1, **caractérisé en ce que** la grandeur de la première correction prédéfinie est supérieure ou inférieure à la grandeur de la deuxième correction prédéfinie, en fonction du fait que la première plage couvre une résistance spécifique qui est inférieure ou supérieure à la résistance spécifique couverte par la deuxième plage.
